# EUROPEAN PATENT APPLICATION

(11) **EP 2 081 224 A1**
(43) Date of publication of application: **22.07.2009**
(21) Application number: 08150918.4
(22) Date of filing: 31.01.2008
(51) Int. Cl.: H01L 21/768

(54) **Maskless method of preparing metal contacts in a semiconductor substrate for bonding**

(30) Priority: 27.12.2007 US 17110 P
(71) Applicant: Interuniversitair Microelectronica Centrum vzw (IMEC), 3001 Leuven (BE)
(72) Inventor: Beyne, Eric, 3001, Leuven (BE); Swinnen, Bart, 3220, Holsbeek (BE); Ruythooren, Wouter, 3150, Tildonk (BE)
(74) Representative: Hertoghe, Kris Angèle Louisa

(57) **Abstract**

A method is disclosed for preparing metal contacts (30) in a semiconductor substrate (10), the method comprising obtaining the metal contacts to protrude from a surface of the semiconductor substrate, the semiconductor substrate having a passivation layer (40) over the surface and over the protruding metal contacts, and removing parts of the passivation layer to reveal the protruding metal contacts without requiring alignment of a patterned mask to the locations of the metal contacts.

## Description

### Technical field of the invention

This invention relates to methods of preparing metal contacts in a semiconductor substrate, to prepare the contacts for external coupling.

### Background of the invention

As is discussed in a publication "Cu-Cu bonding alternative to solder based micro-bumping", by Ruythooren, Beltran and Labie, many 3D chip stacking concepts use face-to-face bonding using flipchip or micro-bump connections (Proc. 9th Electronics Packaging Technology Conference (EPTC) 2007, p. 315-318, Dec. 10-12, 2007, Singapore). Direct Au-Au or Cu-Cu electrical connections between the chip faces are known and may be advantageous over solder or conductive adhesive based approaches for several reasons. Preparing dies or wafers for direct Cu-Cu bonding requires fewer processing steps overall, with no UBM (under barrier metallization), solder or adhesive deposition and patterning. The resulting joints, consisting of just one metal, are less complex, which can be expected to result in more easily predicted reliability. At the same time, with decreasing bump size (in both diameter and height), and in switching from easily deformed solders to Cu, the tolerances on uniformity for the bumps become stricter. A surface planarization step could then ensure that these tolerances are indeed met.

It is known to prepare surfaces of the Cu contacts by chemical-mechanical polishing (CMP), then recess etching to leave the Cu contacts proud of the surface. It is known that CMP causes problem such as dishing, where the center of the bump becomes concave. Moreover, cost of the chemical solutions used in CMP and the environmental concerns are also issues for CMP. Surface planarization by diamond bit cutting is also known as an alternative technique for bump planarization and surface preparation. In this technique, a diamond cutting bit moves over the wafer performing a milling type operation. An example is described in K. Arai, A. Kawai, M. Mizukoshi, H. Uchimura, "A new planarization technique by high precision diamond cutting for packaging", International Symposium on Semiconductor Manufacturing (ISSM), Proceedings, 534-537, Tokyo, 27-29 September 2004.

It is also known to provide a passivated device by coating with a passivating material then using a patterned mask and conventional lithography to open the passivating material over the contacts.

### Summary of the invention

One object of certain aspects of the invention is to provide good apparatus or methods for preparing metal contacts for external coupling.

According to a first aspect, the invention provides:
A method of preparing metal contacts in a semiconductor substrate, to prepare the contacts for external coupling, the method having the steps of:
   obtaining the metal contacts to protrude from a surface of the semiconductor substrate, the semiconductor substrate being provided with a passivation layer over the surface and over the protruding metal contacts, and
   removing parts of the passivation layer to reveal the protruding metal contacts without requiring alignment of a patterned mask to the locations of the metal contacts.

By avoiding the need for such alignment, the number of steps, the costs, and the amount of equipment used can be reduced. This can help make the method more useful for lower cost applications.

Embodiments of the invention can have any other additional features, and some such additional features are set out in dependent claims and described in more detail below.

Any of the additional features can be combined together and combined with any of the aspects. Other advantages will be apparent to those skilled in the art. Numerous variations and modifications can be made without departing from the claims of the present invention. Therefore, it should be clearly understood that the form of the present invention is illustrative only and is not intended to limit the scope of the present invention.

### Brief description of the drawings

How the present invention may be put into effect will now be described by way of example with reference to the appended drawings, in which:
Figures 1 to 4 show cross-sectional views of different stages of preparation according to an embodiment of the invention,
Figures 5 to 7 show cross-sectional views of different stages of preparation according to another embodiment of the invention, and
Figures 8 to 10 show steps of methods according to embodiments of the invention.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, over, and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification do not necessarily all refer to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Aspects of the invention will now be described by a detailed description of several embodiments. It is clear that other embodiments of the invention can be configured according to the knowledge of persons skilled in the art without departing from the technical teaching of the invention, the invention being limited only by the terms of the appended claims.

### Additional features:

Some of the additional features for dependent claims and described in more detail below are as follows:
The removing step can be arranged to leave the protruding metal contacts free of remaining parts of the passivation layer. This can help make a subsequent bonding step easier and more positive.
The passivation layer can be formed to be more compressible than the metal contact. This can help make the contact more positive during a subsequent compression type bonding step
The forming of the metal contacts can be carried out without a chemical -mechanical profiling step. This can help reduce the costs and reduce environmental damage of the process.
The removing step can comprise a mechanical removal operation. This can be a milling or other mechanical operation for example and can be cheaper and cause less damage to other parts than a comparable etching step for example.
The method can involve forming a resist layer over the passivation layer before the removing step, so that the resist layer is thinner over the protruding metal contacts. This can help prepare for the removing step.
The removing step can involve an etching step to remove the thinner parts of the resist layer. The removing step can involve etching to reveal the protruding metal contacts using remaining parts of the resist layer as a mask. This can help enable the etch to remove only the parts of the passivation layer over the metal contacts, and ensure good coverage of the surface of the semiconductor by the passivation layer. This means the protrusions are used to automatically align the mask and thus align the etching. This can avoid the need for a separate step of forming and aligning a patterned mask. This helps reduce costs and time of manufacture and is particularly valuable as feature sizes become smaller, and the alignment becomes more difficult.
The forming of the resist layer to be thinner over the metal contacts can involve a mechanical removal step such as a milling step to remove parts of the resist layer that protrude because of the underlying protruding metal contacts. Alternatively the forming of the resist layer to be thinner over the metal contacts can involve forming the resist layer using a planarizing technique. This can help reduce the number of steps, and therefore reduce costs.
The forming of the metal contacts can involve forming a barrier layer between the metal contacts and the semiconductor substrate, so that the barrier layer protrudes from the surface of the semiconductor substrate, and the metal contacts protrude from the barrier layer. This can help ensure there is a good seal between the passivation layer and the barrier layer, to reduce the risk of contamination such as metal diffusing into and damaging the semiconductor layer.
The forming of the metal contacts can involve a mechanical planarizing step to planarize protruding ends of the metal contacts before forming the passivation layer. This can help make a subsequent bonding of the metal contacts more uniform and reliable. Alternatively, in embodiments having mechanical removal of the thinner parts of the resist layer after forming the passivation layer, this could be continued to planarize protruding ends of the metal contacts.

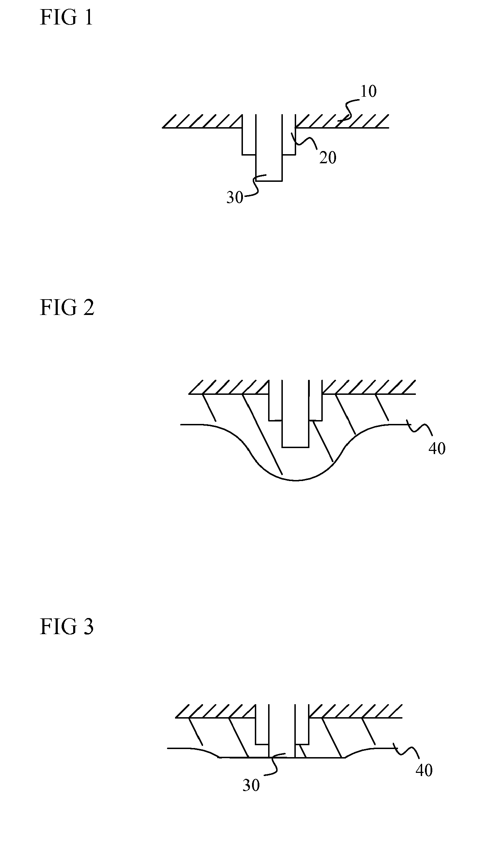

### Figs 1 to 3 and 8, first embodiment (fly cutting without resist)

At least some of the embodiments are concerned with forming soft metal contacts on the backsides of silicon substrates. A front side of the substrate can be processed separately to create functional devices such as transistors using conventional techniques typically including lithography steps. By forming contacts on the backside, the substrate can be stacked with other substrates, to increase density of circuitry. However the conventional technique of forming the backside contacts by embedding them deeply in the front surface then opening the contacts from the back side, has some disadvantages. If the silicon is ground away nearly to the copper, followed by CMP for the final stage, to leave the copper protruding, this is difficult to combine with passivation of the backside. It is well known that passivation is needed when metals like copper are used, to prevent the copper migrating or diffusing into the silicon and causing damage. Passivation by deposition of an oxide or nitride for example is not compatible with a thermal limit of around 200 to 300 degrees C set by the use of glues usually used to fasten the chip temporarily during manufacture, to enable the back side processing.

The term "substrate" may include any underlying material or materials that may be used, or upon which a device, a circuit or an epitaxial layer may be formed. In other alternative embodiments, this "substrate" may include a semiconductor substrate such as e.g. a doped silicon, a gallium arsenide (GaAs), a gallium arsenide phosphide (GaAsP), an indium phosphide (InP), a germanium (Ge), or a silicon germanium (SiGe) substrate.

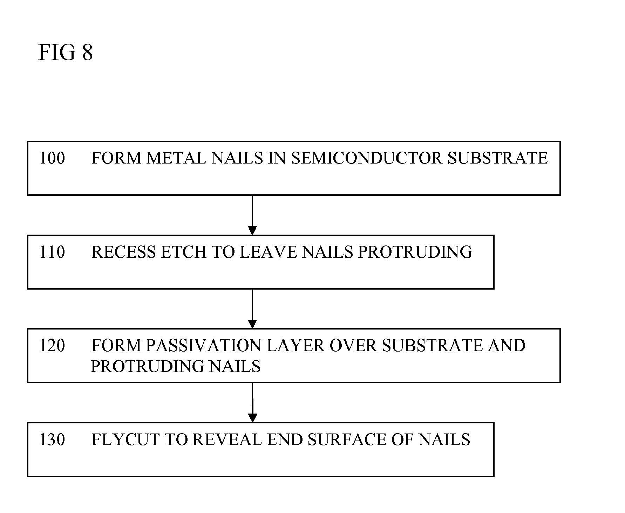

Fig 8 shows a sequence of steps according to a first embodiment. At step 100 metal nails are formed in a semiconductor substrate. This can be carried out by conventional techniques. For example, in a silicon wafer of thickness of a few tens of microns, or within a range of 10 to 50 microns, holes are etched from a front side, and a barrier layer is formed in the hole. The hole may be deepened then filled with the metal of the contact such as Cu or Au or other metal suitable for bonding. A back grinding step is carried out then a recess etch is carried out at step 110 to leave the metal contact protruding as shown in Fig 1. Fig 1 shows the substrate 10, the barrier layer 20 also called a liner, surrounding the contact metal 30, which may also be called a nail. The barrier layer protrudes from the surface of the semiconductor by a few hundred nm. The contact metal protrudes even further. The diameter of the nail can be about 1 to about 2 microns, or in a range of about 0.5 to about 5 microns for example. The material and thickness of the barrier layer can be chosen according to the materials of the semiconductor and of the nail.

At step 120 of Fig 8, a passivating layer 40 is formed over the substrate and over the protruding nails. The passivating layer 40 can be a polymer such as BCB, poly-imide, parylene, etc. In some cases a polymer that is more compressible than the metal can be chosen, so as to enable the metal to protrude during a subsequent compression bonding step. An oxide for the passivation layer is possible in principle but is more difficult to deposit within the above mentioned temperature limits and is likely to be less compressible and hard to remove from the top of the nails if deposited in a conformal way rather than a planarizing way. The passivating layer 40 covering the nail is shown in figure 2.

At step 130 of Fig 8, a mechanical removal step is carried out, such as a milling operation carried out by a diamond fly cutter, for example. This step is carried out to remove the passivation layer from the tops of the nails to leave them ready for bonding. The top of the nails can also be removed, to planarize the nails to make a face-to-face bonding more reliable. This can compensate for height variations in the nails introduced by etch variations or warping of the wafer for example. Figure 3 shows a cross sectional view of an example after the fly cutting step. The nail does not protrude, but may do so during a compression bonding step.

Fly cutting is essentially a milling type operation. It can be performed, for example, by a surface planer, such as a fully automatic surface planer DFS8910 obtainable from Disco Corporation, Japan, see the website "http://www.discousa.com/eg/products/description/description15.html"). Such a fully automatic surface planer DFS8910 has been used for performing bump planarization to lower connection defects by planarizing bump structures formed on a substrate and making the bump structures dimpleless. The surface planer DFS8910 rotates a single crystal diamond bit which is attached to a spindle or wheel at a designated cutting height and performs highly accurate planarization by feeding a wafer from the side. After the wafer is fed into the surface planer DFS8910, the wafer is vacuumed down to a chuck table and cut with the diamond bit. This bit typically rotates at high speeds, for example 5000 rpm.

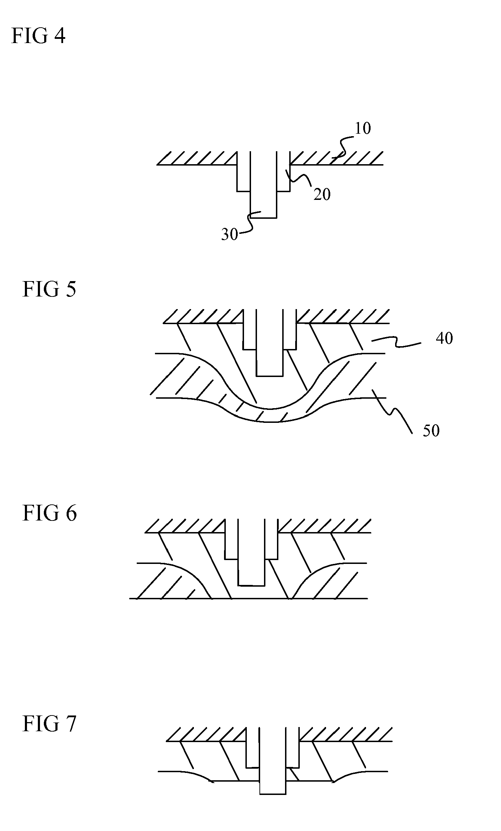

### Figures 4 to 7 and 9, a second embodiment (resist with etching, without fly cutting).

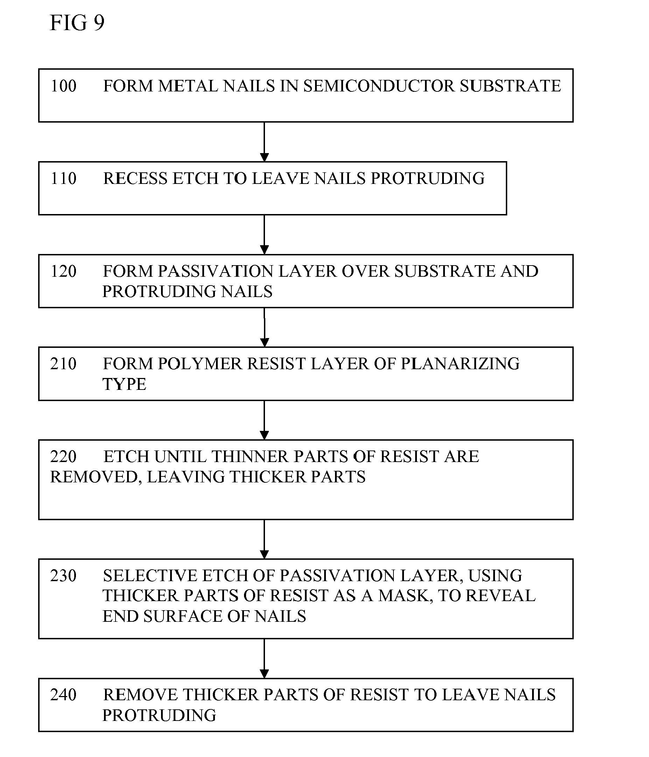

In another embodiment, the first three steps shown in figure 9 are the same as shown in figure 8 and corresponding reference numerals 100, 110, and 120 have been used as appropriate. In this case the passivation layer need not be restricted to a polymer and could be an oxide for example. Figure 4 shows a cross sectional view of the substrate with the nail protruding. After the passivation layer has been formed as discussed above, a polymer resist layer 50 is formed using a planarizing technique, such as spin coating, at step 210. This means that the resist layer is thinner or even absent where the nails protrude. This is shown in figure 5. The resist may for example be an epoxy- or novolac-based polymer. Then, at step 220 of Fig 9, an etch step is carried out to remove the thinner parts of the resist. This etch step can use conventional etch materials according to the type of resist. This should leave the thicker parts of the resist, as shown by figure 6, so that a mask is formed automatically without needing a step of aligning a pattern to create the mask. The etching can continue until the passivation layer is removed from the end of the nails. Optionally this can rely on the thickness of the remaining parts of the resist layer, or depending on the material of the passivation layer, it can involve switching over to a more selective etch which attacks the passivation layer instead of the resist layer, as shown by step 230 of Fig 9. This would be useful if the passivation layer is a hard oxide layer.

Depending on the type of passivation material, and if the etch does not remove the material of the nail, if desired, this etch can be continued further until the passivation layer is below the level of the nail, to leave the nail free of the passivation layer. Then at step 240, the resist layer is removed, as shown in figure 7. The passivation layer can be an oxide of thickness of about 100nm or within a range of about 50 to about 250nm. The passivation layer can be an oxynitride, or a silicon nitride for example.

### Figures 4 to 7 and 10, a third embodiment, resist with fly cutting.

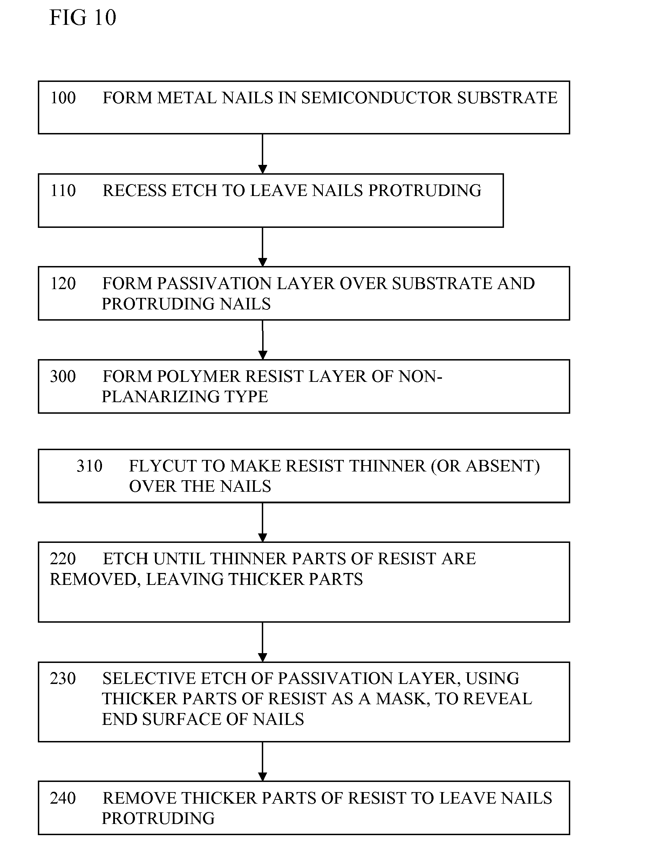

In another embodiment, the first three steps shown in figure 10 are the same as shown in figures 8 and 9 and corresponding reference numerals 100, 110, and 120 have been used as appropriate. In this case the passivation layer can be an oxide rather than a polymer, if desired. Instead of step 210 of forming the thinner parts of the resist by using a planarizing technique, in this embodiment two steps 300 and 330 are used. A conformal coating of polymer resist can be used at step 300, and a mechanical removal step such as the fly-cutting discussed above can be used at step 310 to make the parts above the metal contacts thinner. The fly cutting could in principle be continued to remove the passivation layer, thus replacing step 220 of figure 9. Alternatively a partly planarized coating of resist can be used, and a combination of etching and mechanical removal could be used. As shown in figure 10, steps 220 to 240 can be used, as described above with respect to figure 9. Figures 4 to 7 show cross sections applicable to this embodiment, though only showing a planarizing resist, not a conformal resist.

Other variations can be envisaged within the scope of the claims.

## Claims

1. A method of preparing metal contacts (30) in a semiconductor substrate (10), to prepare the contacts for external coupling, the method comprising the steps of:
obtaining the metal contacts to protrude from a surface of the semiconductor substrate,
the semiconductor substrate having a passivation layer (40) over the surface and over the protruding metal contacts, and
removing parts of the passivation layer to reveal the protruding metal contacts without requiring alignment of a patterned mask to the metal contacts.

2. The method of claim 1, wherein the removing step is arranged to leave the protruding metal contacts free of remaining parts of the passivation layer.

3. The method of claim 1 or 2, wherein the passivation layer is formed to be more compressible than the metal contact.

4. The method of any preceding claim, wherein the metal contacts are formed without a chemical -mechanical profiling step.

5. The method of any preceding claim, wherein the removing step comprises a mechanical removal operation.

6. The method of any preceding claim, further comprising forming a resist layer (50) over the passivation layer before the removing step, wherein the resist layer is thinner over the protruding metal contacts.

7. The method of claim 6, wherein the removing step comprises an etching step to remove the thinner parts of the resist layer.

8. The method of claim 7, wherein the removing step comprises using parts of the resist layer as a mask and etching to reveal the protruding metal contacts.

9. The method of claim 6, wherein forming the resist layer to be thinner over the protruding metal contacts comprises a mechanical removal step that removes parts of the resist layer that protrude because of the underlying protruding metal contacts.

10. The method of claim 6, wherein forming the resist layer to be thinner over the metal contacts comprises using a planarizing technique.

11. The method of any preceding claim, further comprising forming a barrier layer (20) between the metal contacts and the semiconductor substrate, such that the barrier layer protrudes from the surface of the semiconductor substrate, and the metal contacts protrude from the barrier layer.

12. The method of any preceding claim, further comprising a step of mechanical removal to planarize protruding ends of the metal contacts.
